**Europäisches Patentamt**

**European Patent Office**

**Office européen des brevets**

(19)

(11) Veröffentlichungsnummer: **0 291 945 B1**

(12)

# EUROPÄISCHE PATENTSCHRIFT

(45) Veröffentlichungstag der Patentschrift: **25.11.92**

(21) Anmeldenummer: **88107928.9**

(22) Anmeldetag: **18.05.88**

(51) Int. Cl.5: **C23C 14/34**, C03C 17/245, C23C 14/08, G02B 1/10

(54) **Sputtertarget zur Erzeugung optisch transparenter Schichten und Verfahren zur Herstellung dieser Targets.**

(30) Priorität: **20.05.87 DE 3716852**

(43) Veröffentlichungstag der Anmeldung:
**23.11.88 Patentblatt 88/47**

(45) Bekanntmachung des Hinweises auf die
Patenterteilung:
**25.11.92 Patentblatt 92/48**

(84) Benannte Vertragsstaaten:
**BE CH DE ES FR GB IT LI LU NL**

(56) Entgegenhaltungen:
**EP-A- 0 257 463**
**DE-A- 3 318 828**
**US-A- 3 877 913**

(73) Patentinhaber: **DEMETRON Gesellschaft für Elektronik-Werkstoffe m.b.H.**
**Leipziger Strasse 10**
**W-6450 Hanau 1(DE)**

Patentinhaber: **Degussa Aktiengesellschaft**
**Weissfrauenstrasse 9**
**W-6000 Frankfurt am Main 1(DE)**

(72) Erfinder: **Schlamp, Günther Dr., Dipl-.Chem.,**
**Stettiner Strasse 25,**
**W-6374 Steinbach(DE)**
Erfinder: **Gall, Klaus-P.,**
**Ulmenstrasse 38,**
**W-6458 Rodenbach 1(DE)**
Erfinder: **Langer, Adolf**
**In den Steinäckern 12,**
**W-6458 Rodenbach 1(DE)**
Erfinder: **Ptaschek, Georg**
**Aussenliegend 93,**
**W-6365 Rosbach(DE)**

(74) Vertreter: **Weber, Wolfgang**
**Degussa AG Fachbereich Patente Rodenbacher Chaussee 4 Postfach 1345**
**W-6450 Hanau(DE)**

EP 0 291 945 B1

## Beschreibung

Die Erfindung betrifft ein Sputtertarget zur Erzeugung von optisch transparenten, in Verbindung mit Silberschichten wärmereflektierenden Oberflächenschichten auf transparentem Material, wie Glas- und Kunststoffscheiben, aus Wismut mit 0,2 bis 10 Gew.% Mangan und ein Verfahren zur Herstellung dieser Sputtertargets.

Es ist bekannt, Architekturglasscheiben und transparente Kunststoffolien durch Beschichten mit dünnen, optisch transparenten Schichten aus Silber zu versehen, um eine verstärkte Reflexion der Wärmestrahlung zu erzielen. Man erreicht damit sowohl einen Schutz vor zu starker Wärmeeinstrahlung ins Gebäude von außen als auch verminderte Energieverluste bei geheizten Gebäuden durch Wärmestrahlung von innen nach außen. Vielfach werden dazu auch Kombinationen von mehreren Schichten angewandt. So haben sich insbesondere dreischichtige Anordnungen bewährt, die aus einer Metalloxid-Haftschicht, einer infrarotstrahlenreflektierenden Silberschicht und einer darauf aufgebrachten Entspiegelungsschicht aus Metalloxid bestehen.

Für die Herstellung solcher Schichten wird allgemein das Verfahren der Kathodenzerstäubung in einer Glimmentladung, das sogenannte Sputtern, angewandt. Dazu werden die als Schicht aufzutragenden Metalle, Metall-Legierungen und Metalloxide als speziell geformte Festkörper, z.B. Platten, Ringe oder auch Teile von komplexerer Geometrie - die sogenannten Targets - benutzt.

Die Zerstäubung (Sputtern) erfolgt durch Auftreffen geladener Gasatome auf der Targetoberfläche, wodurch von dieser einzelne Atome oder Atomgruppen herausgeschlagen werden. Diese treffen dann auf der gegenüberliegenden Oberfläche der zu beschichtenden Glasoberfläche auf und bilden dort entsprechende Oberflächenschichten. Das Verfahren arbeitet üblicherweise in Edelgasatmosphäre, z. B. Argon, unter vermindertem Druck mit angelegten elektrischen Spannungen oder hochfrequenten Wechseltrömen (RF) in Gleichstrom-(DC) oder Hochfrequenz-Wechselstromschaltung.

Werden der Edelgasatmosphäre zusätzlich Sauerstoff- oder Stickstoffanteile beigegeben, so können je nach Metallart des Targets auch Oxid- oder Nitridschichten gebildet werden. Mit dieser Methode können beispielsweise Oxid-Haftschichten und Oxid-Entspiegelungsschichten unter Verwendung von metallischen Targets hergestellt werden. Meist werden hierzu Wismut-Targets verwendet und Wismutoxidschichten aufgebracht.

Es ist bekannt, daß reine Wismut-Oxidschichten in direktem Kontakt mit Silberschichten bei UV-Bestrahlung eine Schwärzung verursachen. Dies kann vermieden werden, wenn zwischen der Silberschicht und den Wismut-Oxidschichten andere Metalloxidschichten aufgebracht werden, die bei UV-Bestrahlung keine Schwärzung verursachen. Bekannte Beispiele sind Blei-Oxid, Indium-Oxid oder Indium-Zinn-Oxid.

Aus der DE-PS 32 11 753 sind Sputtertargets zur Erzeugung von optisch transparenten, in Verbindung mit Silberschichten wärmereflektierenden Oberflächenschichten aus Wismutoxid auf transparentem Material, wie Glasscheiben und Kunststoffolien, bekannt, die aus Wismut mit 0,2 bis 10 Gew.% Mangan bestehen. Über den Aufbau und die Herstellung dieser Targets werden allerdings keine Angaben gemacht.

Bei Verwendung dieser bekannten Sputtertargets aus Wismut mit 0,2 bis 10 Gew.% Mangan, hergestellt durch Pressen und gegebenenfalls Sintern einer entsprechenden Pulvermischung aus Wismut und Mangan entstehen beim Sputtern in sauerstoffhaltiger Edelgasatmosphäre zwar manganoxidhaltige Wismutoxidschichten, die die Schwärzung der Silberschichten bei UV-Bestrahlung unterdrücken, doch hat es sich gezeigt, daß bei Langzeiteinwirkung der UV-Strahlung doch eine allmähliche Schwärzung der Silberschicht eintrifft.

Es war daher Aufgabe der vorliegenden Erfindung, Sputtertargets zur Erzeugung von optisch transparenten, in Verbindung mit Silberschichten wärmereflektierenden Oberflächenschichten auf transparentem Material, wie Glas- und Kunststoffscheiben aus Wismut und 0,2 bis 10 Gew.% Mangan so weiterzuentwickeln, daß auch bei Langzeiteinwirkung von UV-Bestrahlung keine merkliche Schwärzung der Silberschicht eintritt. Außerdem sollte ein Verfahren zur Herstellung dieser Sputtertargets gefunden werden.

Diese Aufgabe wird erfindungsgemäß dadurch gelöst, daß das Mangan in Form der intermetallischen Verbindung BiMn in gleichmäßiger, feindisperser Verteilung innerhalb der metallischen Wismut-Matrix vorliegt.

Vorteilhafterweise weisen diese BiMn-Teilchen einen Durchmesser von $\leq 10 \ \mu m$ auf. Außerdem sollte die metallische Wismutmatrix Korngrößen von höchstens 200 $\mu m$ aufweisen, insbesondere Korngrößen von 10 bis 100 $\mu m$, und die Teilchen der Matrix möglichst keine kristallographische Vorzugsorientierung zeigen.

Für die Stabilisierung des reaktiv durchgeführten Sputtervorgangs unter Zugabe von geringen, definierten Mengen an Sauerstoff hat es sich als günstig erwiesen, wenn in den Targets bereits ein gewisser Sauerstoffgehalt vorliegt. Dieser sollte jedoch 2000 ppm nicht überschreiten. Als optimal haben sich Sauerstoffgehalte in den Bi-BiMn-Targets unterhalb 1000 ppm, insbesondere zwischen 500 ppm und 800 ppm erwiesen. Außerdem sollte die Targetmatrix über die Gesamtabmessung einen Dichteunterschied von höchstens ± 1 % der mittleren Targetdichte zeigen.

Überraschenderweise hat sich gezeigt, daß im Falle der aufgesputterten manganhaltigen Wismutoxidschichten die dauerhafte Unterdrückung der Schwärzung von damit in direktem Kontakt stehenden Silberschichten dann gelingt, wenn das Mangan in den dafür zu reaktiven Sputtern benutzten metallischen Wismuttargets in Form der feindispers verteilten, definierten BiMn-Verbindung innerhalb der Wismut-Metallmatrix vorliegt. Targets, die aus Pulvermischungen aus elementarem Wismut und Mangan durch Pressen und Sintern hergestellt wurden, lassen sich zwar störungsfrei absputtern, jedoch ergeben die damit hergestellten Wismut-Mangan-Oxidschichten eine allmähliche Schwärzung der damit in direkter Verbindung stehenden Silber-Schichten bei langdauernder UV-Bestrahlung.

Für die Beschichtung nach dem Sputterprozeß werden zur Intensivierung der Schichtbildungsgeschwindigkeit Magnetfelder innerhalb der Glimmentladung erzeugt, die die zur Abtragung des Targetmaterials benötigten Argon-Ionen auf bestimmte Oberflächenbereiche des Targets konzentrieren. Zur Erzeugung dieser Magnetfelder werden unterhalb des Targets, d.h. an derjenigen Seite des Targets, an dem es auf der Träger- bzw. Rückplatte befestigt ist, Magnete angebracht. Diese Vorrichtung funktioniert normalerweise nur, wenn das Targetmaterial selbst unmagnetisch ist. Bei ferromagnetischem Targetmaterial kann die verstärkende Wirkung durch Magnetfelder auf diese Weise nur dann erzielt werden, wenn die Targetmatrix nur schwach magnetisch ist. Außerdem dürfen bei Targets mit mehrphasigen, heterogenen Gefügestrukturen keine inhomogen verteilten magnetischen Bereiche in der Targetmatrix vorliegen, da diese die erzeugten Magnetfelder schwächen und dadurch örtlich ungleichmäßigen Abtrag der Targets bewirken. Auf diese Weise entstehen auf den zu beschichtenden Substraten örtlich unterschiedliche Schichtdicken.

Die Verbindung BiMn, die erfindungsgemäß besonders vorteilhaft anstelle von elementarem Mn benutzt wird, ist im Gegensatz zu diesem ferromagnetisch. Bei Anwendung des durch Magnetfelder intensivierten Sputtervorganges ist es deshalb für Targets aus manganhaltigem Wismut, bei denen das Mangan in Form der BiMn-Verbindung vorliegt, von besonderer Wichtigkeit, daß die BiMn-Verbindung in Form kleinster Teilchen, z.B. kleiner als 10 $\mu$m vorliegt und daß diese gleichmäßig ohne örtliche Anreicherungen oder Verarmungen innerhalb der Matrix verteilt sind.

Die erfindungsgemäßen Sputtertargets lassen sich herstellen, indem man Wismutpulver mit vorher durchreagiertem BiMn-Pulver (Bi : Mn = 1:1) gleichmäßig vermischt, zusammenpreßt und gegebenenfalls sintert.

Dabei sollten die BiMn-Teilchen eine Korngröße von höchstens 10 $\mu$m und die Wismutteilchen eine Korngröße von höchstens 200 $\mu$m besitzen. Vorzugsweise verwendet man aber Pulver, die durch Zerstäuben einer schmelzflüssigen Wismut-Mangan-Legierung im Vakuum oder in inerter Gasatmoshäre hergestellt wurden. Diese Pulver werden zunächst durch isostatisches Pressen verdichtet, die Preßlinge dann bei Temperaturen unterhalb 260° C gesintert und anschließend durch Strangpressen zu Target-Rohlingen mit einer mittleren Dichte von über 99 % der theoretischen Dichte verarbeitet.

Die nachfolgenden Beispiele sollen die Erfindung näher erläutern:

1. Eine schmelzflüssige Legierung aus Wismut mit 1 Gew. % Mangan wird in Argon-Atmosphäre zu Pulver verdüst. Nach Absieben der Körner über 200 um Durchmesser wird die verbleibende Hauptmenge, die eine Korngröße ≤ 200 $\mu$m aufweist, isostatisch mit einem Druck von 200 MPa zu einem Rundbarren verpreßt. Der Rohling weist danach eine Dichte > 96 % der theoretischen Dichte auf, bei einer mittleren Korngröße von rund 60 $\mu$m. In diesen Körnern ist die BiMn-Verbindung mit einer Normgröße von 1 - 10 $\mu$m feindispers verteilt. Anschließend erfolgt eine Wärmebehandlung in $N_2$-Atmosphäre bei 250° C über eine Zeitdauer von zwei Stunden. Danach wird der Barren durch Strangpressen zu flachen Targetrohlingen verpreßt. Die Dichte des Materials beträgt dann 99% der theoretischen Dichte. Mit diesen Targets werden beim Sputtern einwandfreie gleichmäßige Mn-haltige Wismut-Oxidschichten erhalten, die in direkter Berührung mit Silber-Schichten keine Schwärzung bei längerer UV-Strahlung verursachen.

2. Verdüstes Wismut-Metallpulver mit Korngrößen ≤ 200 $\mu$m und mechanisch zerkleinerte BiMn-Verbindungsbrocken mit Korngrößen ≤ 10 $\mu$m werden mechanisch gemischt und anschließend isostatisch zu einem Rundbarren verpreßt, wobei ein Druck von 200 MPa angewandt wird. Der Rohling weist danach eine Dichte von ca. 88% der theoretischen Dichte auf. Durch anschließendes Sintern bei 255° C wird eine Verdichtung auf ca. 92% der theoretischen Dichte bewirkt. Durch Strangpressen bei 150° C erfolgt die Formgebung zu Targetrohlingen, die danach eine Dichte von 98 - 99% haben. Diese Targets ergeben einwandfreie Beschichtungsresultate und verursachen bei direkter Berührung mit Silber-Schichten keine Schwärzung bei langanhaltender UV-Einstrahlung.

## Patentansprüche

1. Sputtertarget zur Erzeugung von optisch transparenten, in Verbindung mit Silberschichten wärmereflektierenden Oberflächenschichten auf transparentem Material, wie Glas- und Kunststoffscheiben, aus Wismut mit 0,2 bis 10 Gew.% Mangan, dadurch gekennzeichnet, daß das Mangan in Form der intermetallischen Verbindung BiMn in gleichmäßiger, feindisperser Verteilung innerhalb der metallischen Wismut-Matrix vorliegt.

2. Sputtertarget nach Anspruch 1, dadurch gekennzeichnet, daß die BiMn-Teilchen eines Durchmesser von ≤ 10 μm aufweisen.

3. Sputtertarget nach Anspruch 1 und 2, dadurch gekennzeichnet, daß die Teilchen der metallischen Wismutmatrix Korngrößen von ≤ 200 μm aufweisen.

4. Sputtertarget nach Anspruch 1 bis 3, dadurch gekennzeichnet, daß die Teilchen der Wismut-Matrix Korngrößen von 10 bis 100 μm aufweisen.

5. Sputtertarget nach Anspruch 1 bis 4, dadurch gekennzeichnet, daß die Teilchen der Wismut-Matrix keine kristallgraphische Vorzugsorientierung zeigen.

6. Sputtertarget nach Anspruch 1 bis 5, dadurch gekennzeichnet, daß das Targetmaterial einen Sauerstoffgehalt nicht über 2000 ppm aüfweist.

7. Sputtertarget nach Anspruch 1 bis 6, dadurch gekennzeichnet, daß der Sauerstoffgehalt des Targetmaterials unterhalb von 1000 ppm liegt.

8. Sputtertarget nach Anspruch 1 bis 7, dadurch gekennzeichnet, daß die Targetmatrix über die Gesamtabmessung einen Dichteunterschied von höchstens ± 1% der mittleren Targetdichte aufweist.

9. Verfahren zur Herstellung von Sputtertargets nach einem oder mehreren der Ansprüche 1 bis 8, dadurch gekennzeichnet, daß Wismutpulver mit durchreagiertem BiMn-pulver (Bi : Mn = 1:1) gleichmäßig vermischt, zusammengepreßt und gegebenenfalls gesintert wird.

10. Verfahren zur Herstellung von Sputtertarget nach Anspruch 9, dadurch gekennzeichnet, daß die Pulverteilchen durch Zerstäuben einer Wismutlegierung mit 0,2 bis 10 Gew.% Mangan im Vakuum oder einer sauerstofffreier Schutzgasatmosphäre hergestellt werden.

11. Verfahren nach Anspruch 9 und 10, dadurch gekennzeichnet, daß die gepressten Formkörper unterhalb 260°C gesintert und anschließend durch Strangpressen zu Formkörper mit einer mittleren Dichte von über 99% der theoretischen Dichte weiterverarbeitet werden.

## Claims

1. Sputtering target for the production of optically transparent surface layers reflecting heat in combination with silver layers on transparent material such as glass and plastics panes, composed of bismuth with from 0.2 to 10% by weight of manganese, characterised in that the manganese is present in the form of the intermetallic compound BiMn finely dispersed and uniformly distributed within the metallic bismuth matrix.

2. Sputtering target according to claim 1, characterised in that the BiMn particles have a diameter of ≤ 10 μm.

3. Sputtering target according to claims 1 and 2, characterised in that the particles of the metallic bismuth matrix have particle sizes ≤ 200 μm.

4. Sputtering target according to claims 1 to 3, characterised in that the particles of the bismuth matrix have particle sizes of from 10 to 100 μm.

5. Sputtering target according to claims 1 to 4, characterised in that the particles of the bismuth matrix have no preferential crysallographic orientation.

6. Sputtering target according to claims 1 to 5, characterised in that the target material has an oxygen content not exceeding 2000 ppm.

7. Sputtering target according to claims 1 to 6, characterised in that the oxygen content of the target material is below 1000 ppm.

8. Sputtering target according to claims 1 to 7, characterised in that the target matrix has a density difference over its whole dimensions of at most ± 1% of the average target density.

9. A process for the production of the sputtering target according to one or more of claims 1 to 8, characterised in that bismuth powder is uniformly mixed with completely reacted BiMn powder (Bi : Mn 1:1), compressed and optionally sintered.

**10.** A process for the production of sputtering target according to claim 9, characterised in that the powder particles are prepared by atomisation of a bismuth alloy with from 0.2 to 10% by weight of manganese in a vacuum or an oxygen-free protective gas atmosphere.

**11.** A process according to claims 9 and 10, characterised in that the pressed moulded bodies are sintered at below 260°C and then converted by extrusion moulding into moulded bodies having and average density above 99% of the theoretical density.

**Revendications**

**1.** Cible de pulvérisation cathodique pour la production de couches superficielles optiquement transparentes, renvoyant la chaleur en relation avec des couches d'argent, sur un matériau transparent, tel que des disques de verre ou de matière plastique, à base de bismuth avec 0,2 à 10 % en poids de manganèse, caractérisée en ce que le manganèse se trouve sous forme du composé intermétallique BiMn en dispersion homogène finement dispersée au sein de la matrice de bismuth métallique.

**2.** Cible de pulvérisation cathodique selon la revendication 1, caractérisée en ce que les particules de BiMn ont un diamètre ≦ 10 μm.

**3.** Cible de pulvérisation cathodique selon la revendication 1 ou 2, caractérisée en ce que les particules de la matrice de bismuth métallique ont des tailles de particules ≦ 200 μm.

**4.** Cible de pulvérisation cathodique selon l'une quelconque des revendications 1 à 3, caractérisée en ce que les particules de la matrice de bismuth ont des tailles de particules allant de 10 à 100 μm.

**5.** Cible de pulvérisation cathodique selon l'une quelconque des revendications 1 à 4, caractérisée en ce que les particules de la matrice de bismuth ne présentent pas d'orientation cristallographique préférentielle.

**6.** Cible de pulvérisation cathodique selon l'une quelconque des revendications 1 à 5, caractérisée en ce que le matériau de la cible présente une teneur en oxygène n'excédant pas 2000 ppm.

**7.** Cible de pulvérisation cathodique selon l'une quelconque des revendications 1 à 6, caractérisée en ce que la teneur en oxygène du matériau de la cible est inférieure à 1000 ppm.

**8.** Cible de pulvérisation cathodique selon l'une quelconque des revendications 1 à 7, caractérisée en ce que la matrice de la cible présente sur toute sa dimension une différence de densité d'au maximum ± 1 % de la densité moyenne de la cible.

**9.** Procédé pour la fabrication de la cible de pulvérisation cathodique selon une ou plusieurs des revendications 1 à 8, caractérisé en ce que la poudre de bismuth est mélangée uniformément avec de la poudre de BiMn ayant cessé de réagir (Bi : Mn = 1:1), compressée et éventuellement frittée.

**10.** Procédé pour la fabrication de la cible de pulvérisation cathodique selon la revendication 9, caractérisé en ce que les particules de poudre sont préparées par pulvérisation d'un alliage de bismuth avec 0,2 à 10 % en poids de manganèse, sous vide ou dans une atmosphère d'un gaz protecteur, exempte d'oxygène.

**11.** Procédé selon les revendications 9 et 10, caractérisé en ce que les corps moulés comprimés sont frittés au-dessous de 260°C et ensuite retransformés par extrusion en corps moulés ayant une densité moyenne de plus de 99 % de la densité théorique.